# EUROPÄISCHE PATENTSCHRIFT

(11) **EP 0 542 772 B1**
(45) Veröffentlichungstag und Bekanntmachung des Hinweises auf die Patenterteilung: **29.05.1996**
(21) Anmeldenummer: 91913305.8
(22) Anmeldetag: 31.07.1991
(51) Int. Cl.: H01L 41/09

(54) **KONTAKTIERUNG EINES PIEZOELEKTRISCHEN BIEGEWANDLERS**
BONDING OF A PIEZO-ELECTRIC BENDING TRANSDUCER
CONNEXION D'UN TRANSDUCTEUR PIEZOELECTRIQUE DE FLEXION

(30) Priorität: 10.08.1990 DE 4025436
(43) Veröffentlichungstag der Anmeldung: 26.05.1993
(73) Patentinhaber: SIEMENS AKTIENGESELLSCHAFT, D-80333 München (DE)
(72) Erfinder: STEIN, Christian, W-8000 München 90 (DE); MÖCKL, Thomas, D-8630 Coburg (DE)
(86) Internationale Anmeldenummer: DE9100616
(87) Internationale Veröffentlichungsnummer: WO9202961

(56) Entgegenhaltungen:
- EP-A- 0 388 027
- DE-A- 2 425 268
- GB-A- 2 189 933
- US-A- 4 363 993
- US-A- 4 649 312
- PATENT ABSTRACTS OF JAPAN, Band 12, Nr. 108 (E-597) 17 October 1987 ; & JP-A-62 237 780

## Beschreibung

Die Erfindung bezieht sich auf einen piezoelektrischen Biegewandler mit einer Graphitfaserschicht, die zwischen zwei beidseitig mit Elektroden versehenen Piezokeramik-Schichten mit einem Epoxidharz verklebt ist. Sie bezieht sich weiter auf ein Verfahren zur Herstellung eines solchen piezoelektrischen Biegewandlers.

Wenn ein elektromechanischer Biegewandler der genannten Art an einem Ende fest eingespannt ist und am anderen Ende einen Magnetkopf trägt, dann wird beim Anlegen einer Spannung an den Biegewandler der Magnetkopf um eine dieser Spannung entsprechende Strecke ausgelenkt. Der Biegewandler kann dann in dieser Ausbildung in magnetischen Aufzeichnungs- und Wiedergabegeräten, zum Beispiel in Video-Bandgeräten, eingesetzt werden. Ein weiteres Einsatzgebiet für einen Biegewandler ist neben der Videotechnik auch die Ventiltechnik oder die Blindenschrift-Lesetechnik.

Piezoelektrische Biegewandler bestehen in der Regel aus zwei piezokeramischen Plättchen ader Schichten, die auf beiden Seiten einer Metall- oder Kunststoffolie - die auch gewebeverstärkt sein kann - aufgeklebt sind. Die Keramikplättchen sind auf ihren beiden Seiten mit einer Metallisierung versehen. Sie werden vor oder auch nach dem Verkleben mit der Metall- oder Kunststoffolie zum Bimorph polarisiert. Dabei werden sie in ein elektrisches Feld von beispielsweise 700 V/mm eingebracht und auf diese Weise piezoelektrisch gemacht. Legt man nun ein Potential von zum Beispiel 170 V an die inneren Elektroden der beiden piezokeramischen Plättchen und von 0 V an die beiden äußeren Elektroden, dann entsteht ein elektrisches Feld, dessen Richtung in der oberen und in der unteren Keramik entgegengesetzt ist. Durch den piezoelektrischen Effekt wird das eine piezokeramische Plättchen länger und das andere kürzer werden. Der Biegewandler verbiegt sich. Er kann somit als elektromechanisches Stellelement verwendet werden und hat die oben beispielsweise angegebenen Einsatzgebiete.

Aus der DE-A-30 46 535 ist ein piezoelektrischer Biegewandler der eingangs genannten Art bekannt. Bei diesem Biegewandler ist zwischen den beiden Piezokeramik-Schichten nicht eine Schicht aus Metall oder Kunststoff, sondern eine Graphit- oder Kohlenstoff-Faserschicht angeordnet. Die einzelnen Kohlenstofffasern sind in ein Epoxidharz eingebettet. Von besonderer Bedeutung ist es, daß bei diesem elektromechanischen Wandler die Kohlenstoffasern in einer gemeinsamen Richtung verlaufen, also alle parallel zueinander angeordnet sind. Die einzelnen Graphitfasern sind dabei so gelegt, daß sie parallel zu der Richtung verlaufen, in der sich der elektromechanische Wandler zur Erzeugung der Auslenkung dehnen oder kürzen soll. Es ist dabei davon ausgegangen, daß in dieser Richtung die Graphitfaserschicht ihren größten Elastizitätsmodul besitzt. Senkrecht hierzu ist der Elastizitätsmodul wesentlich geringer. Die piezoelektrischen Keramikplatten können zum Beispiel aus einer Blei-Zirkonat-Titan-Keramik hergestellt sein. Der Biegewandler ist praktisch quadratisch dimensioniert. Über die Kontaktierung der einzelnen Elektroden ist in dieser Druckschrift nichts angegeben.

Ein ähnlicher piezoelektrischer Biegewandler mit einer zwischen zwei Piezokeramikschichten eingesetzten Kohlenstoff-Faserschicht ist durch die US-A-4 363 993 von Nishigaki et al bekannt. Bei diesem piezoelektrischen Biegewandler wird die Betriebsspannung nur an den Außenelektroden angelegt. Die Innenelektroden sind ohne äußere Anschlüsse.

Aus der Zusammenfassung von JP 62-237780 in "Patent Abstracts of Japan, Band 12, Nr. 108, E597" ist ein piezoelektrischer Biegewandler bekannt, der eine leitfähige, elastische Zwischenschicht hat, die mit einem elektrischen Kontakt versehen ist. Es ist jedoch nichts darüber bekannt, aus welchem Material die Zwischenschicht ist und inwiefern die Kontaktierung der Zwischenschicht erfolgte.

Aufgabe der Erfindung ist es, einen Biegewandler der eingangs genannten Art anzugeben, bei dem die Kontaktierung der Innenelektroden der beiden Piezokeramik-Schichten auf sichere und einfache Weise vorgenommen werden kann, bei dem also der elektrische Anschluß nicht allzuviel Aufwand erfordert. Weiterhin soll ein Verfahren zur Herstellung eines solchen Biegewandlers angegeben werden.

Die erstgenannte Aufgabe wird erfindungsgemäß dadurch gelöst, daß die Graphitfaserschicht eine größere Länge besitzt als die beiden Piezokeramik-Schichten, daß auf dem freien Teil der Graphitfaserschicht eine Kupferfolie verklebt ist, und daß auf der Kupferfolie eine Fläche zum Anbringen eines Lötkontakts vorgesehen ist.

Hierbei wird also die Graphitfaser-Schicht als gemeinsame Elektrode verwendet und mit einem elektrischen Anschluß für die beiden innenliegenden Elektroden versehen. Dies läßt sich relativ einfach durchführen.

Um den Kontakt zwischen Kupferfolie und Graphitfaser-Schicht besonders gut zu gestalten, besitzt die Kupferfolie eine vorbehandelte, der Graphitfaser-Schicht zugewandte Oberfläche, die mit einer rauhen Schicht aus Zink, Nickel oder Kupfer belegt ist.

Die Aufgabe bezüglich des Verfahrens wird erfindungsgemäß dadurch gelöst, daß eine Graphitfaser-Schicht, die mit nicht völlig ausgehärtetem Epoxidharz getränkt ist, zwischen zwei polarisierte Piezokeramik-Schichten gelegt und dort bei Aushärtung des Epoxidharzes verklebt wird, und daß auf das Graphitfaser- Gewebe eine Kupferfolie aufgeklebt wird, vorzugsweise gleichzeitig mit dem Verkleben der beiden Piezokeramik-Schichten, wobei die Kupferfolie vor dem Aufkleben vorbehandelt mid, midem ihre Oberfläche aufgerauht oder mit einer dünnen rauhen Metallschicht aus Zink, Nickel oder Kupfer belegt wird.

Weitere vorteilhafte Ausgestaltungen sind in den Unteransprüchen beschrieben.

Ausführungsbeispiele der Erfindung werden im folgenden anhand der Zeichnungen verdeutlicht. Es zeigen:
- FIG 1: einen piezoelektrischen Biegewandler mit Messingfolie als Innenlage zur Verdeutlichung der Problemstellung,
- FIG 2: einen piezoelektrischen Biegewandler mit Kunststoffolie als Innenlage, ebenfalls zur Verdeutlichung der Problemstellung,
- FIG 3: einen erfindungsgemäßen piezoelektrischen Biegewandler.

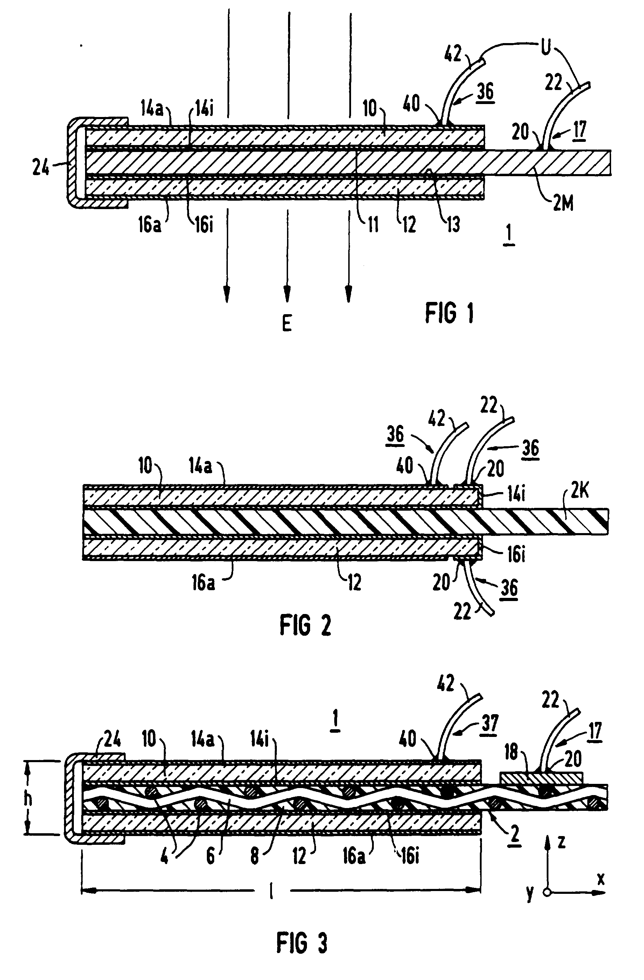

Nach Figur 1 umfaßt ein Biegewandler 1 eine Metallfolie oder Metallschicht 2M, auf deren beiden Seiten Piezokeramik-Plättchen oder -Schichten 10, 12 aufgeklebt sind. Die Piezokeramik-Schichten 10, 12 sind auf beiden Seiten mit einer Metallisierung oder Elektrode versehen. Die Innenelektroden sind mit 14i, 16i und die Außenelektroden sind mit 14a, 16a bezeichnet. Zwischen den Schichten 2M, 10 und 12 befinden sich relativ dicke Schichten 11 bzw. 13 aus einem Kleber. Die Metallfolie 2M, die insbesondere aus Messing bestehen kann, ist rechts etwas länger als die beiden Piezokeramik-Schichten 10, 12. Im freien Bereich befindet sich ein elektrischer Anschluß 16, das heißt eine Kontaktierung mit einer Lötstelle 20, zu der ein Verbindungsdraht 22 führt. Entsprechend ist an der oberen Außenelektrode 14a eine elektrische Verbindung 36 mit Lötstelle 40 und Anschlußdraht 42 vorgesehen. Auf der anderen (linken) Seite sorgt ein metallischer Bügel 24 für einen Kontakt der beiden Außenelektroden 14a, 16a miteinander.

Die Keramikplättchen 10, 12 werden vor oder nach dem Verkleben polarisiert, indem man sie in ein elektrisches Feld E von beispielsweise 700 V/mm bringt und sie so piezoelektrisch macht. Bei Anlegen einer Spannung U an die Zuleitungsdrähte 22, 42 verbiegt sich der Biegewandler 1.

Der in Figur 1 gezeigte Aufbau mit Messingfolie 2M als Innenlage hat den Vorteil, daß die innenliegende Metallisierung 14i, 16i der Piezokeramik-Schichten 10, 12 auf einfache Weise ankontaktiert werden kann. Denn der Kleber 11, 13 kann so dünn gewählt werden, daß die wegen der rauhen Oberfläche der Keramiken 10, 12 immer vorhandenen Spitzen und Erhebungen an vielen Stellen den Kleber 11, 13 durchdrinaen und daß so ein zuverlässiger Kontakt zwischen der Metallfolie 2M und den innenliegenden Metallisierungsschichten 14i, 16i hergestellt wird. Zudem können auf einfache Weise die Drähte 22, 42 zur elektrischen Weiterverdrahtung angelötet werden.

Der Aufbau mit Messingfolie 2M hat jedoch auch gravierende Nachteile. Zum einen ist Messing schwierig zu verkleben, zum anderen haben Messing und Piezokeramik sehr verschiedene thermische Ausdehnungskoeffizienten. Dadurch entstehen in Abhängigkeit von der Klebetemperatur und der Gebrauchstemperatur Zug- oder Druckspannungen in der Piezokeramik 10, 12. Klebt man bei Zimmertemperatur und wird der Biegewandler 1 im Gerät, in dem er eingebaut ist, erwärmt, dann entstehen in der Piezokeramik 10, 12 Zugspannungen, und sie wird reißen. Klebt man jedoch bei höherer Temperatur, zum Beispiel bei 130 °C, dann ist man zwar sicher, daß der Biegewandler im Gebrauch kaum höheren Temperaturen ausgesetzt sein wird; die Keramik 10, 12 wird aber unter Druckspannung stehen. Hat man eine Keramik 10, 12 verklebt, die bereits vorpolarisiert war, dann führen die mechanischen Spannungen zur Depolarisation und damit zu einer Schwächung des Piezoeffekts. Die Durchbiegung wird kleiner.

Metallschichten 2M mit einem der Keramik 10, 12 angepaßten thermischen Ausdehnungskoeffizienten können wegen ihrer Korrosionsanfälligkeit meist nicht eingesetzt werden. Zudem sind sie schlecht lötbar, so daß die Weiterverdrahtung wieder schwierig wird.

Polarisiert man dagegen den geklebten Verbund, dann reißt die Keramik 10, 12. Die Polarisation ist nämlich mit einer Ausrichtung von Domänen in den Körnern der Keramik 10, 12 verbunden. Aus der kristallographischen Anisotropie der Piezokeramik 10, 12 resultiert damit eine Formänderung. Das betreffende Keramikplättchen 10, 12 wird kürzer und dicker. Da es fest mit dem Messingblech 2M verklebt ist, kann es nicht schwinden und reißt.

In Figur 2 ist gezeigt, daß anstelle einer Metallfolie 2M prinzipiell auch eine Kunststoffolie 2K verwendet werden kann. In diesem Fall ist die Ankontaktierung der inneren Elektroden 14i, 16i schwierig, weil sie an einen nicht-leitfähigen Kunststoff 2K angrenzen. Man kann dann die innenliegende Metallisierung 14i, 16i über die (in Figur 2 rechts liegende) Kante der jeweiligen Piezokeramik 10, 12 nach oben bzw. unten führen, um kontaktieren zu können. Auf diese Weise erhält man zwei Kontaktierungsstellen 36. Das ist technologisch alles sehr aufwendig.

In Figur 3 ist ein piezoelektrischer Biegewandler dargestellt, bei dem den besagten Kontaktierungsproblemen begegnet ist.

Nach Figur 3 umfaßt der piezoelektrische Biegewandler 1 als wesentliches Element eine Graphitfaserschicht 2, die aus in Längsrichtung x verlaufenden Kohlenstoffasern 4 und in der dazu senkrechten Querrichtung y verlaufenden Kohlenstofffasern 6 sowie aus Epoxidharz 8 besteht. Die einzelnen miteinander verwobenen Kohlenstoffasern 4 und 6 bilden somit ein Kohlenstofffaser-Gewebe, das mit dem Epoxidharz 8 getränkt ist. Die Ausbildung als Gewebe mit über Kreuz liegenden Fasern 4 und 6 verleiht der Graphitfaserschicht 2 eine ausreichende Stabilität. Die Graphitfaserschicht 2 ist zwischen zwei dünnen Piezokeramik-Plättchen oder -Schichten 10, 12, die beidseitig mit Elektroden 14a, 14i bzw. 16a, 16i versehen sind, eingeklebt.

Die in Längsrichtung x gemessene Länge 1 des Biegewandlers 1 ist um mindestens des Faktor 3 größer als seine in der dazu senkrechten Richtung y gemessene Breite b. Beispielsweise kann der Biegewandler 1 eine in x-Richtung gemessene Länge 1 = 80 mm, eine in y-Richtung gemessene Breite b = 2 mm und eine in z-Richtung gemessene Höhe h = 1 mm besitzen. Die Graphitfaserschicht 2 ist länger als die beiden gleich langen Keramik-Schichten 10 und 12. Sie ist im (rechts gelegenen) freien Bereich mit einem elektrischen Anschluß 17 versehen. Im vorliegenden Ausführungsbeispiel handelt es sich dabei um eine auf die Graphitfaserschicht 2 aufgeklebte Kupferfolie 18, die an ihrer Oberseite eine Fläche für eine Kontaktierung 20 aus Lot besitzt, an die ein elektrischer Verbindungsdraht 22 geführt ist.

An der anderen (linken) Seite besitzt der Biegewandler 1 einen Bügel 24 aus Metall, der die beiden äußeren Elektroden 14a, 16a der Piezokeramik-Schichten 10 bzw. 12 miteinander verbindet.

Als Piezokeramik-Schichten 10, 12 werden insbesondere langgestreckte Scheiben aus Blei-Zirkonat-Titan-Keramik (PZT-Schichten) herangezogen. Bevorzugt werden Piezokeramik-Schichten 10, 12 eingesetzt, die einen positiven Temperaturgang der Piezokonstanten haben, der im Bereich von -20 °C bis +60 °C gleich/größer 3,5 %./K ist. Vorzugsweise liegt der Temperaturgang in diesem Bereich zwischen 4 und 7 %./K. Der stark positive Temperaturgang hat zur Folge, daß mit steigender Temperatur die Verzerrung der Keramik-Schichten 10, 12 und damit der Biegeeffekt zunimmt. Mit steigender Temperatur wird das Epoxidharz 8 in der Schicht 2 in zunehmendem Maße weich. Dieser Effekt wird durch den erwähnten positiven Temperaturgang des Piezomaterials kompensiert, so daß die Blockierkraft des piezoelektrischen Biegewandlers 1 praktisch bei allen Arbeitstemperaturen gleich bleibt.

Die Elektroden 14a, 14i, 16a, 16i auf den Piezokeramik-Schichten 10 bzw. 12 sind dünne Edelmetall-Schichten, deren Dicke z.B. nur 50 bis 100 nm beträgt. Von Vorteil ist es, einen Schichtenauftrag in der Reihenfolge Cr-Pt-Au zu verwenden.

Zur Herstellung des Biegewandlers 1 ist folgendes zu sagen: Ausgangspunkt ist ein Kohlenstoffaser-Gewebe mit über Kreuz liegenden Fasern 4, 6, welches mit Epoxidharz 8 getränkt ist, das noch nicht ganz ausgehärtet wurde. Ein solches Material befindet sich im sogenannten B-Zustand, und das Material ist auch unter dem Namen "Prepreg" bekannt. Dieses "Prepreg" ist hervorragend geeignet, sich mit den Piezokeramik-Plättchen oder -Schichten 10, 12, wie man sie für den Biegewandler 1 benötigt, zu verbinden. Dieses "Prepreg" hat einen der Piezokeramik gut oder weitestgehend angepaßten thermischen Ausdehnungskoeffizienten. Daher kann mit vorpolarisierter Piezokeramik heiß verklebt werden, ohne daß später im Verbund mechanische Spannungen entstehen, die Depolarisation der Piezokeramik oder Risse verursachen würden. Zusammenfassend kann man sagen, daß das Prepreg-Material 4, 6, 8 in noch nicht völlig ausgehärtetem Zustand zwischen die beiden polarisierten Piezokeramik-Schichten 10, 12 gelegt und dort unter Aushärtung des Epoxidharzes 8 verklebt wird.

Zur Aushärtung des Epoxidharzes 8 und zum festen Verkleben mit den beiden Schichten 10, 12 kann beispielsweise die Temperatur erhöht werden. Die Temperatur beim Aushärten und Verkleben kann beispielsweise etwa 130 °C betragen.

Untersuchungen haben gezeigt, daß die elektrische Leitfähigkeit des Kohlenstoffaser-Gewebes 4, 6 für die Potentialzufuhr voll ausreicht; und die Kontaktierung mit den Innenelektroden 14, 16 der beiden Piezokeramik-Schichten 10, 12 ist noch inniger als bei einer Metallfolie anstelle der Graphitfaserschicht 2, da durch die Webart eine zusätzliche Oberflächenstruktur angeboten wird.

Wie in Figur 3 dargestellt, kann das Problem der Kontaktierung des ausgehärteten Kohlenstoffaser-Gewebes 2 folgendermaßen gelöst werden: Auf das Prepreg 2 wird in dem Bereich, welcher von den Piezokeramik-Schichten 10, 12 nicht bedeckt wird und auf welchem der Kontakt 17 zu den inneren Elektroden 14, 16 hergestellt werden soll, die Kupferfolie 18 laminiert. Dieser Vorgang erfolgt gleichzeitig mit dem Verkleben der beiden Piezokeramik-Schichten 10, 12 auf der Graphitfaserschicht 2. Den Kleber liefert das Prepreg, weil es voraussetzungsgemäß nicht ganz ausgehärtetes Epoxidharz 8 enthält. In der Fachsprache spricht man vom "Laminieren".

Um eine gute Haftung der Kupferfolie 18 auf der Schicht 2 zu erzielen, ist es zweckmäßig, eine Kupferfolie 18 zu verwenden, deren zu verklebende Oberfläche vorbehandelt ist. Eine solche Vorbehandlung kann bestehen aus dem Auftragen von elektrolytisch abgeschiedenem Zink oder Nickel, wodurch eine rauhe Oberfläche erzeugt wird. Auch durch Abscheidung von Kupfer bei hoher Stromdichte kann elektrolytisch eine rauhe, gut klebbare Oberfläche auf der Kupferfolie 18 erhalten werden.

Der gezeigte Lötstützpunkt 17 aus Kupferfolie 18 besitzt eine ausgezeichnete Lötbarkeit, und der elektrische Kontakt zum Kohlenstoffaser-Gewebe 2 ist zuverlässig und niederohmig.

Ein weiterer Lötstützpunkt 37 ist auf der Außenelektrode 14a vorgesehen. Er umfaßt eine Lot-Kontaktierung 40 mit Verbindungsdraht 42.

## Patentansprüche

1. Piezoelektrischer Biegewandler (1) mit einer Graphitfaser-schicht (2), die zwischen zwei beidseitig mit Elektroden (14i, 14a, 16i, 16a) versehenen Piezokeramikschichten (10, 12) mit einem Epoxidharz (8) verklebt ist,
**dadurch gekennzeichnet,** daß
die Graphitfaserschicht (2) eine größere Länge (1) besitzt als die beiden Piezokeramikschichten (10, 12), daß
auf dem freien Teil der Graphitfaserschicht (2) eine Kupferfolie (18) verklebt ist, daß
die Kupferfolie (18) eine vorbehandelte, der Graphitfaserschicht (2) zugewandte Oberfläche besitzt, die mit einer rauhen Schicht aus Zink, Nickel oder Kupfer belegt ist, und daß
auf der Kupferfolie (18) eine Fläche zum Anbringen eines Lötkontakts (16) vorgesehen ist.

2. Verfahren zum Herstellen eines Biegewandlers nach Anspruch 1,
**dadurch gekennzeichnet,** daß eine Graphitfaserschicht (2), die mit nicht völlig ausgehärtetem Epoxidharz (8) getränkt ist, zwischen zwei polarisierte Piezokeramikschichten (10, 12) gelegt und dort bei Aushärtung des Epoxidharzes (8) verklebt wird, und daß auf das Graphitfasergewebe (4, 6) eine Kupferfolie (18) aufgeklebt wird, vorzugsweise gleichzeitig mit dem Verkleben der beiden Piezokeramikschichten (10, 12), wobei die Kupferfolie (18) vor dem Aufkleben vorbehandelt wird, indem ihre Oberfläche aufgerauht oder mit einer dünnen rauhen Metallschicht aus Zink, Nickel oder Kupfer belegt wird.

3. Verfahren nach Anspruch 2,
**dadurch gekennzeichnet,** daß die Schicht aus Zink oder Nickel durch elektrolytische Abscheidung aufgebracht wird.

4. Verfahren nach Anspruch 2,
**dadurch gekennzeichnet,** daß die Schicht aus Kupfer durch elektroytische Abscheidung bei hoher Stromdichte aufgebracht wird.

## Claims

1. A piezoelectric bending transducer (1) having a graphite fibre layer (2) that is glued by means of an epoxy resin (8) between two piezoceramic layers (10, 12) provided on both sides with electrodes (14i, 14a, 16i, 16a),
characterised in that
- the graphite fibre layer (2) has a greater length (1) than the two piezoceramic layers (10, 12),
- a copper foil (18) is glued on to the exposed part of the graphite fibre layer (2),
- the copper foil (18) has a pretreated surface facing the graphite fibre layer (2), which is coated with a rough layer of zinc, nickel or copper, and
- an area for attaching a soldering contact (16) is provided on the copper foil (18).

2. A process for producing a bending transducer according to claim 1, characterised in that a graphite fibre layer (2) which is impregnated with not yet completely hardened epoxy resin (8) is placed between two polarized piezoceramic layers (10, 12) and glued into position there as the epoxy resin (8) is hardened, and that a copper foil (18) is glued on to the graphite fibre fabric (4, 6), preferably simultaneously with the gluing of the two piezoceramic layers (10, 12), the copper foil (18) being pretreated before the gluing by roughening its surface or providing it with a thin rough metallic layer of zinc, nickel or copper.

3. A process according to claim 2, characterised in that the layer of zinc or nickel is applied by electrodeposition.

4. A process according to claim 2, characterised in that the layer of copper is applied by electrodeposition at high current density.

## Revendications

1. Transducteur (1) piézoélectrique de flexion comportant une couche (2) de fibres de graphite, qui est collée par une résine (8) époxy entre deux couches (10, 12) de céramique pièzoélectrique munies des deux côtés d'électrodes (14i, 14a, 16i, 16a),
caractérisé en ce que
la couche (2) de fibres de graphite a une longueur (1) supérieure à celle des deux couches (10, 12) de céramique pièzoélectrique,
une feuille (18) de cuivre est collée sur la partie libre de la couche (2) de fibre de graphite,
la feuille (18) de cuivre a une surface prétraitée, qui est tournée vers la couche (2) de fibres de graphite et qui est revêtue d'une couche rugueuse de zinc, de nickel ou de cuivre, et
il est prévu sur la feuille (18) de cuivre une surface pour la mise en place d'un contact (16) à braser.

2. Procédé de fabrication d'un transducteur de flexion suivant la revendication 1,
caractérisé en ce que l'on met une couche (2) de fibres de graphite, qui est imprégnée de résine (8) époxy non complètement durcie, entre deux couches (10, 12) de céramique piézoélectrique polarisées et on l'y colle par le durcissement de la résine (8) époxy, on colle sur le tissu (4, 6) en fibres de graphite une feuille (18) de cuivre, de préférence en même temps que le collage des deux couches (10, 12) de céramique piézoélectrique, on traite au préalable la feuille (18) de cuivre avant le collage, en en rendant la surface rugueuse ou en la revêtant d'une couche métallique mince et rugueuse de zinc, de nickel ou de cuivre.

3. Procédé suivant la revendication 2,
caractérisé en ce que l'on dépose la couche de zinc ou de nickel par dépôt électrolytique.

4. Procédé suivant la revendication 2,
caractérisé en ce que l'on dépose la couche de cuivre par dépôt électrolytique à grande densité de courant.
